# EUROPEAN PATENT SPECIFICATION

(11) **EP 4 632 421 B1**
(45) Date of publication and mention of the grant of the patent: **28.10.2026**
(21) Application number: 25183711.8
(22) Date of filing: 23.09.2021
(51) Int. Cl.: G01R 31/374, G01R 31/382, G01R 31/364, G01R 31/385, G01R 31/396, G01R 31/28, G01R 31/3835, G01R 35/00

(54) **BATTERY APPARATUS AND METHOD FOR MEASURING CELL VOLTAGE**
BATTERIEVORRICHTUNG UND VERFAHREN ZUR MESSUNG DER ZELLENSPANNUNG
APPAREIL DE BATTERIE ET PROCÉDÉ DE MESURE DE TENSION DE CELLULE

(30) Priority: 06.10.2020 KR 20200128638
(43) Date of publication of application: 15.10.2025
(62) Document number(s) of the earlier application(s) in accordance with Art. 76 EPC: 21877888.4 / 4 080 230
(73) Proprietor: LG ENERGY SOLUTION, LTD., Seoul 07335 (KR)
(72) Inventor: KIM, Minwoo, 34122 Daejeon (KR); SEO, Bo Hyun, 34122 Daejeon (KR); LEE, Seunghyun, 34122 Daejeon (KR); KIM, Tae Youn, 34122 Daejeon (KR)
(74) Representative: Hoffmann Eitle

(56) References cited:
- US-A1- 2016 233 700
- US-A1- 2019 260 095
- US-A1- 2020 033 412

## Description

### [Technical Field]

### CROSS-REFERENCE TO RELATED APPLICATION

This application claims priority to and the benefit of Korean Patent Application No. 10-2020-0128638 filed in the Korean Intellectual Property Office on October 6, 2020.

The described technology relates to a battery apparatus and a method for measuring a cell voltage.

### [Background Art]

An electric vehicle or a hybrid vehicle is a vehicle that obtains power by driving a motor mainly using a battery as a power supply. The electric vehicles are being actively researched because they are alternatives that can solve pollution and energy problems of internal combustion vehicles. Rechargeable batteries are used in various external apparatuses other than the electric vehicles.

Recently, as a battery having a high output and a large charging capacity is required, a battery pack in which a plurality of battery modules are connected in series is used. Since each battery module includes a plurality of battery cells, it is required to measure a voltage of the battery cell in order to diagnose the battery.

An integrated circuit (IC)-type cell voltage sensing circuit is used to measure the voltage of the battery cell. Currently, a separate cell voltage sensing IC is connected to each battery module. For example, one or more cell voltage sensing ICs are connected to one battery module, and one or more separate cell voltage sensing ICs are connected to another battery module. Accordingly, as the number of battery modules included in the battery pack increases, the number of required cell voltage sensing ICs increases, and thus the cost of the battery may increase. US 2016/233700 A1 discloses an example of a battery with sensing means connected to different cells.

### [Disclosure]

### [Technical Problem]

In some embodiments, a battery apparatus and a method for measuring a cell voltage for optimizing a cell voltage sensing circuit may be provided.

### [Technical Solution]

According to an embodiment, a battery apparatus may be provided. **The** battery apparatus may include a first battery module including a plurality of battery cells, a second battery module including a plurality of battery cells, a bus-bar connecting a first electrode terminal of the first battery module and a second electrode terminal of the second battery module, a cell voltage sensing circuit, and a processor. **The** cell voltage sensing circuit may be shared by at least some battery cells of the first battery module and at least some battery cells of the second battery module, and may measure a voltage of each battery cell and a voltage of the bus-bar. **The** processor may correct a voltage of at least one battery cell among the some battery cells of the first battery module and the some battery cells of the second battery module based on the voltage of the bus-bar.

**In** some embodiments, the processor may correct the voltage of the at least one battery cell by subtracting the voltage of the bus-bar from the voltage of the at least one battery cell measured by the cell voltage sensing circuit.

**In** some embodiments, the first electrode terminal may be a negative terminal of the first battery module, and the at least one battery cell may include a battery cell connected to the negative terminal among the plurality of battery cells of the first battery module.

**In** some embodiments, the second electrode terminal may be a positive terminal of the second battery module, and the at least one battery cell may include a battery cell connected to the positive terminal among the plurality of battery cells of the second battery module.

**In** some embodiments, the cell voltage sensing circuit may be provided in a form of an integrated circuit (IC) having a plurality of pins. **The** plurality of battery cells of the first battery module may include a first battery cell connected to the first electrode terminal, and the plurality of battery cells of the second battery module may include a second battery cell connected to the second electrode terminal. **In** this case, a contact between the first electrode terminal and the first battery cell and a contact between the second electrode terminal and the second battery cell may be respectively connected to a first pin and a second pin for the bus-bar among the plurality of pins. A contact between the second electrode terminal and the second battery cell may be connected to a pin for battery cell voltage sensing among the plurality of pins.

In some embodiments, the at least one battery cell may include the first battery cell.

In some embodiments, the first electrode terminal may be a negative terminal of the first battery module, and the second electrode terminal may be a positive terminal of the second battery module. In this case, a contact between the first electrode terminal and the first battery cell may be a negative electrode of the first battery cell, and a contact between the second electrode terminal and the second battery cell may be a positive electrode of the second battery cell.

In some embodiments, the first electrode terminal may be a positive terminal of the first battery module, and the second electrode terminal may be a negative terminal of the second battery module. In this case, a contact between the first electrode terminal and the first battery cell may be a positive electrode of the first battery cell, and a contact between the second electrode terminal and the second battery cell may be a negative electrode of the second battery cell.

According to another embodiment, a method of measuring a cell voltage of a battery apparatus including a first battery module and a second battery module may be provided. The method may include measuring a voltage of each battery cell using a cell voltage sensing circuit shared by at least some battery cells of the first battery module and at least some battery cells of the second battery module, measuring a voltage of a bus-bar connecting the first battery module and the second battery module using the cell voltage sensing circuit, and correcting a voltage of at least one battery cell among the some battery cells of the first battery module and the some battery cells of the second battery module based on the voltage of the bus-bar.

In some embodiments, the correcting the voltage of the at least one battery cell may include correcting the voltage of the at least one battery cell by subtracting the voltage of the bus-bar from the voltage of the at least one battery cell measured by the cell voltage sensing circuit.

In some embodiments, the at least one battery cell may include a battery cell connected to the bus-bar among the some battery cells of the first battery module or a battery cell connected to the bus-bar among the some battery cells of the second battery module.

According to yet another embodiment, a battery apparatus may be provided. **The** battery apparatus may include a plurality of battery modules including a first battery module and a second battery module, a bus-bar connecting the first battery module and the second battery module, and a cell voltage sensing **IC** shared by a plurality of battery cells of the first battery modules and a plurality of battery cells of the second battery module and configured to measure a voltage of each battery cell.

**In** some embodiments, the cell voltage sensing **IC** may have a plurality of pins. A negative electrode of a first battery cell connected to the bus-bar among the plurality of battery cells of the first battery module and a positive electrode of a second battery cell connected to the bus-bar among the plurality of battery cells of the second battery module may be respectively connected to a first pin and a second pin for the bus-bar among the plurality of pins. A positive electrode of the first battery cell and the positive electrode of the second battery cell may be respectively connected to a third pin and a fourth pin for battery cell voltage sensing among the plurality of pins.

In this case, the processor may measure a voltage of the first battery cell by correcting a voltage between the third pin and the fourth pin based on a voltage between the first pin and the second pin.

In some embodiments, the cell voltage sensing IC may have a plurality of pins. A negative electrode of a first battery cell connected to the bus-bar among the plurality of battery cells of the first battery module and a positive electrode of a second battery cell connected to the bus-bar among the plurality of battery cells of the second battery module may be respectively connected to a first pin and a second pin for the bus-bar among the plurality of pins. The negative electrode of the first battery cell and a negative electrode of the second battery cell may be respectively connected to a third pin and a fourth pin for battery cell voltage sensing among the plurality of pins.

In this case, the processor may measure a voltage of the second battery cell by correcting a voltage between the third pin and the fourth pin based on a voltage between the first pin and the second pin.

In some embodiments, the plurality of battery cells of the second battery module may be some battery cells of the second battery module, and the plurality of battery modules may further include a third battery module. In this case, the battery apparatus may further include a second bus-bar connecting the second battery module and the third battery module, and a second cell voltage sensing IC shared by remaining battery cells of the second battery module and a plurality of battery cells of the third battery module.

### [Advantageous Effects]

According to some embodiments, the number of cell voltage sensing circuits connected to the plurality of battery modules may be reduced. According to another embodiment, the voltage of the bus-bar included in the measured voltage of the battery cell may be compensated.

### [Description of the Drawings]

FIG. 1 is a diagram showing a battery apparatus according to an embodiment.
FIG. 2, FIG. 3, and FIG. 4 are diagrams showing a connection relationship between a battery module and a cell voltage sensing circuit in a battery apparatus according to various embodiments.
FIG. 5 is a drawing showing an example of a bus-bar in a battery apparatus according to an embodiment.
FIG. 6, FIG. 7, FIG. 8, and FIG. 9 are diagrams for explaining a voltage measurement of a battery cell in a battery apparatus. Fig. 6 and Fig. 7 are comparative examples which are not part of the invention.
FIG. 10 is a flowchart showing a method of measuring a cell voltage in a battery apparatus according to an embodiment.

### [Mode for Invention]

In the following detailed description, only certain embodiments have been shown and described, simply by way of illustration. As those skilled in the art would realize, the described embodiments may be modified in various different ways, all without departing from the scope of the claims. Accordingly, the drawings and description are to be regarded as illustrative in nature and not restrictive. Like reference numerals designate like elements throughout the specification.

When it is described that an element is "connected" to another element, it should be understood that the element may be directly connected to the other element or connected to the other element through a third element. On the other hand, when it is described that an element is "directly connected" to another element, it should be understood that the element is connected to the other element through no third element.

As used herein, a singular form may be intended to include a plural form as well, unless the explicit expression such as "one" or "single" is used.

In flowcharts described with reference to the drawings, the order of operations or steps may be changed, several operations or steps may be merged, a certain operation or step may be divided, and a specific operation or step may not be performed.

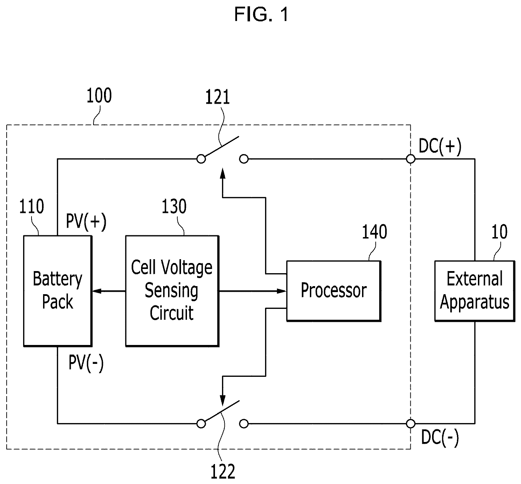

FIG. 1 is a diagram showing a battery apparatus according to an embodiment.

Referring to FIG. 1, a battery apparatus 100 has a structure that can be electrically connected to an external apparatus 10 through a positive link terminal DC(+) and a negative link terminal DC(-). In some embodiments, the battery apparatus 100 may be connected to the external apparatus 10 through the positive link terminal DC(+) and the negative link terminal DC(-). When the external apparatus is a load, the battery apparatus 100 is discharged by operating as a power supply that supplies power to the load. The external apparatus operating as the load may be, for example, an electronic device, a mobility apparatus, or an energy storage system (ESS). The mobility apparatus may be, for example, a vehicle such as an electric vehicle, a hybrid vehicle, or a smart mobility.

The battery apparatus 100 includes a battery pack 110, a positive main switch 121, a negative main switch 122, a cell voltage sensing circuit 130, and a processor 140.

The battery pack 110 has a positive terminal PV(+) and a negative terminal PV(-). The battery pack includes a plurality of battery modules (not shown) connected in series between the positive terminal PV(+) and the negative terminal PV(-), and each battery module includes a plurality of battery cells (not shown). In some embodiments, the plurality of battery cells in each battery module may be connected in series. In some embodiments, the battery cell may be a rechargeable cell. In this way, the plurality of battery modules may be connected in the battery pack 110 to supply desired power.

The positive main switch 121 is connected between the positive terminal PV(+) of the battery pack 110 and the positive link terminal DC(+) of the battery apparatus 100. The negative main switch 122 is connected between the negative terminal PV(-) of the battery pack 110 and the negative link terminal DC(-) of the battery apparatus 100. The switches 121 and 122 may be controlled by the processor 140 to control an electrical connection between the battery pack 110 and the external apparatus. That is, the switches 121 and 122 may control supply of a current of the battery pack 110. In one embodiment, each of the switches 121 and 122 may be a contactor implemented in a relay. In another embodiment, each of the switches 121 and 122 may be an electrical switch such as a transistor. In some embodiments, the battery apparatus 100 may further include driving circuits (not shown) for controlling the switches 121 and 122, respectively.

The cell voltage sensing circuit 130 measures voltages of battery cells of the battery pack 110. In some embodiments, the cell voltage sensing circuit 130 may measure the voltage of the battery cell by sensing voltages at positive and negative electrodes of the battery cell. The processor 140 manages the battery apparatus 100 based on the voltages measured by the cell voltage sensing circuit 130. In some embodiments, the processor 140 may control operations of the switches 121 and 122. The processor 140 may be, for example, a micro controller unit (MCU).

The processor 140 may form a battery management system. In some embodiments, the battery management system may further include a cell voltage sensing circuit 130.

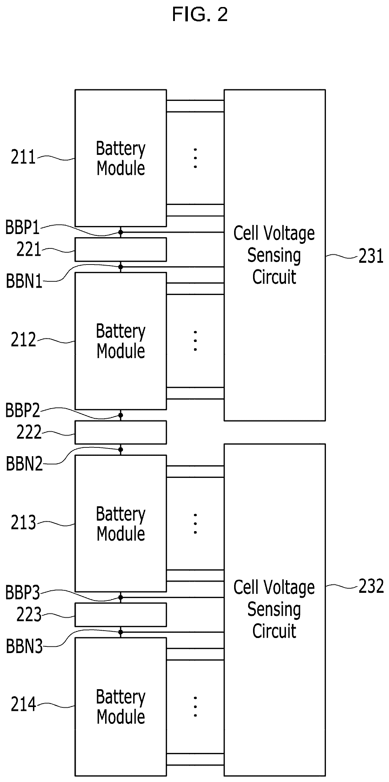

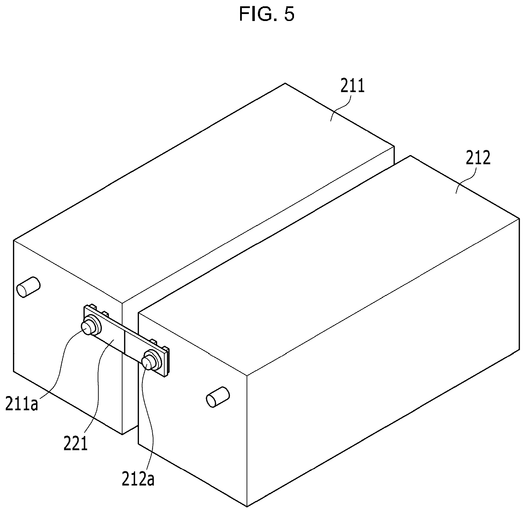

FIG. 2, FIG. 3, and FIG. 4 are diagrams showing a connection relationship between a battery module and a cell voltage sensing circuit in a battery apparatus according to various embodiments, and FIG. 5 is a drawing showing an example of a bus-bar in a battery apparatus according to an embodiment.

Referring to FIG. 2, FIG. 3, and FIG. 4, in a battery pack, a plurality of battery modules 211, 212, 213, and 214 are connected in series. Although FIG. 2, FIG. 3, and FIG. 4 show four battery modules 211, 212, 213, and 214 for convenience of description, the number of battery modules is not limited thereto.

Two adjacent battery modules are connected via a bus-bar. A bus-bar 221 connects the battery module 211 and the battery module 212, a bus-bar 222 connects the battery module 212 and the battery module 213, and a bus-bar 223 connects the battery module 213 and the battery module 214. A first terminal of the bus-bar 221 may be connected to a node BBP1 corresponding to a negative terminal of the battery module 211, and a second terminal of the bus-bar 221 may be connected to a node BBN1 corresponding to a positive terminal of the battery module 212. Further, a first terminal of the bus-bar 222 may be connected to a node BBP2 corresponding to a negative terminal of the battery module 212, and a second terminal of the bus-bar 222 may be connected to a node BBN2 corresponding to a positive terminal of the battery module 213. Furthermore, a first terminal of the bus-bar 223 may be connected to a node BBP3 corresponding to a negative terminal of the battery module 213, and a second terminal of the bus-bar 223 may be connected to a node BBN3 corresponding to a positive terminal of the battery module 214. In some embodiments, the positive terminal of each battery module may be connected to a positive electrode of the last battery cell among a plurality of battery cells, which are included in the corresponding battery module and are connected in series, and the negative terminal of each battery module may be connected to a negative electrode of the first battery cell among the plurality of battery cells, which are included in the corresponding battery module and are connected in series.

In some embodiments, the bus-bars 221, 222, and 223 may be formed of a material having electrical conductivity. The bus-bars 221, 222, and 223 may be formed in various shapes according to a structure of the battery pack 210 or the battery modules 211, 212, 213 and 214. For example, as shown in FIG. 5, the bus-bar 221 may be connected with an electrode terminal 211a of one battery module 211 and an electrode terminal 212a of the other battery module 212 so as to connect the battery module 211 and the battery module 212. The electrode terminal 211a of the battery module 211 may be a negative terminal of the battery module 211, and the electrode terminal 212a of the battery module 212 may be a positive terminal of the battery module 212.

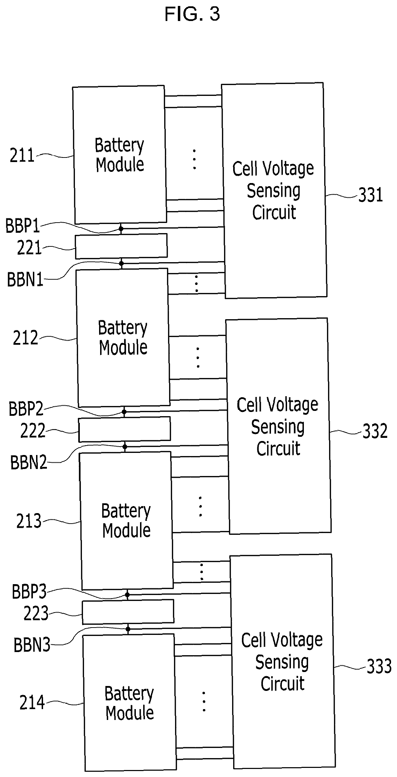

As shown in FIG. 2 and FIG. 3, a cell voltage sensing circuit is connected to two or more battery modules. In this case, the number of battery cells that can be sensed by the cell voltage sensing circuit may be greater than the number of battery cells included in one battery module. In some embodiments, when the cell voltage sensing circuit is provided as an integrated circuit (IC), the number of cell voltage sensing pins (or channels) in the cell voltage sensing IC may be greater than the number of battery cells included in one battery module.

Referring to FIG. 2, a cell voltage sensing circuit 231 may be connected to a plurality of battery cells of battery modules 211 and 212 to measure a voltage of each of the battery cells, and the cell voltage sensing circuit 232 may be connected to a plurality of battery cells of battery module 213 and 214 to measure a voltage of each of the battery cells. In some embodiments, the cell voltage sensing circuit 231 may be connected to the plurality of battery cells of the battery module 211 and the plurality of battery cells of the battery module 212 through a plurality of sensing lines, and the cell voltage sensing circuit 232 may be connected to the plurality of battery cells of the battery module 213 and the plurality of battery cells of the battery module 214 through a plurality of sensing lines. The cell voltage sensing circuits 231 and 232 may sense voltages at the positive and negative electrodes of each battery cell and measure a voltage between the positive and negative electrodes as a voltage of the corresponding battery cell. In this case, a sensing line connected to a positive electrode of a certain battery cell to sense the positive electrode may be also connected to a negative electrode of an adjacent battery cell, and a sensing line connected to a negative electrode of a certain battery cell to sense the negative electrode may be also connected to a positive electrode of another adjacent battery cell.

Further, the cell voltage sensing circuit 231 may measure a voltage of a bus-bar 221 connecting the two battery modules 211 and 212, and the cell voltage sensing circuit 232 may measure a voltage of a bus-bar 223 connecting the two battery modules 213 and 214. The cell voltage sensing circuit 231 may measure a voltage between both terminals of the bus-bar 221, i.e., a voltage between the two nodes BBP1 and BBN1, as the voltage of the bus-bar 221, and the cell voltage sensing circuit 232. may measure a voltage between both terminals of the bus-bar 223, i.e., a voltage between the two nodes BBP3 and BBN3, as the voltage of the bus-bar 223.

In some embodiments, each of the cell voltage sensing circuits 231 and 232 may be provided as a cell voltage sensing IC. In some embodiments, the cell voltage sensing IC 231 may include a plurality of pins respectively connected to a plurality of battery cells of the battery modules 211 and 212 and two pins respectively connected to both terminals BBP1 and BBN1 of the bus-bar 221. Further, the cell voltage sensing IC 232 may include a plurality of pins respectively connected to a plurality of battery cells of the battery modules 213 and 214 and two pins respectively connected to both terminals BBP3 and BBN3 of the bus-bar 223. In this case, the cell voltage sensing IC may measure the voltage of the bus-bar through two pins respectively connected to both terminals of the bus-bar, and measure the voltage of the battery cell through the pins connected to the battery cell.

Referring to FIG. 3, in some embodiments, a cell voltage sensing circuit 331 may be connected to a plurality of battery cells of a battery module 211 and some battery cells of a battery module 212 to measure a voltage of each of the battery cells. The cell voltage sensing circuit 332 may be connected to remaining battery cells of the battery module 212 and some battery cells of a battery module 213 to measure a voltage of each of the battery cells. The cell voltage sensing circuit 333 may be connected to remaining battery cells of the battery module 213 and a plurality of battery cells of a battery module 214 to measure a voltage of each of the battery cells.

Further, the cell voltage sensing circuit 331 may measure a voltage of a bus-bar 221 connecting the two battery modules 211 and 212, the cell voltage sensing circuit 332 may measure a voltage of a bus-bar 222 connecting the two battery modules 212 and 213, and the cell voltage sensing circuit 333 may measure a voltage of a bus-bar 223 connecting the two battery modules 213 and 214.

According to the above-described embodiments, since the cell voltage sensing circuit is connected to two or more battery modules, the number of cell voltage sensing circuits required for the battery apparatus can be reduced, thereby reducing the cost of the battery apparatus. In examples shown in FIG. 2 and FIG. 3, although four cell voltage sensing circuits are required when a separate cell voltage sensing circuit is used for each battery module, two or three cell voltage sensing circuits can be used according to the above- described embodiments.

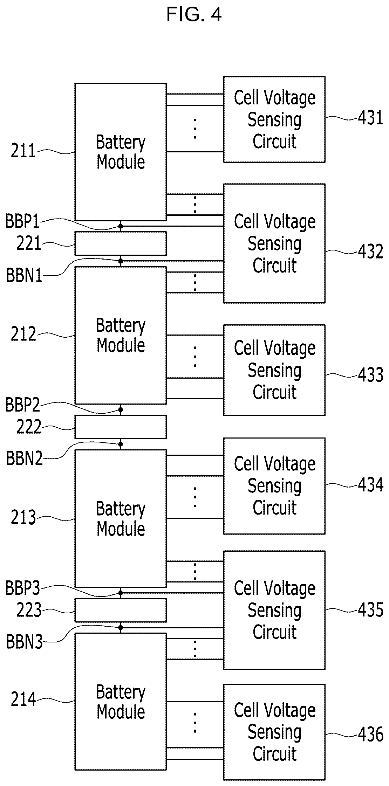

In some embodiments, as shown in FIG. 4, two cell voltage sensing circuits may be connected to one battery module. In this case, the number of battery cells that can be sensed by the cell voltage sensing circuit may be less than the number of battery cells included in one battery module. In some embodiments, when the cell voltage sensing circuit is provided as a cell voltage sensing IC, the number of pins (or channels) of the cell voltage sensing IC may be less than the number of battery cells included in one battery module.

Referring to FIG. 4, a cell voltage sensing circuit 431 may be connected to some battery cells of a battery module 211 to measure a voltage of each of the battery cells, a cell voltage sensing circuit 432 may be connected to remaining battery cells of the battery module 211 and some battery cells of a battery module 212 to measure a voltage of each of the battery cells, and a cell voltage sensing circuit 433 may be connected to remaining battery cells of the battery module 212 to measure a voltage of each of the battery cells. Further, a cell voltage sensing circuit 434 may be connected to some battery cells of a battery module 213 to measure a voltage of each of the battery cells, a cell voltage sensing circuit 435 may be connected to remaining battery cells of the battery module 213 and some battery cells of a battery module 214 to measure a voltage of each of the battery cells, and a cell voltage sensing circuit 436 may be connected to remaining battery cells of the battery module 214 to measure a voltage of each of the battery cells.

Furthermore, a cell voltage sensing circuit 432 may measures a voltage of a bus-bar 221 connecting the two battery modules 211 and 212, and a cell voltage sensing circuit 434 may measure a voltage of a bus-bar 223 connecting the two battery modules 212 and 213.

According to the above-described embodiments, since the cell voltage sensing circuit is connected to two or more battery modules, the number of cell voltage sensing circuits required for the battery apparatus can be reduced, thereby reducing the cost of the battery apparatus. In the example shown in FIG. 4, although eight cell voltage sensing circuits are required when a separate cell voltage sensing circuit is used for each battery module, six cell voltage sensing circuits can be used according to the above-described embodiments.

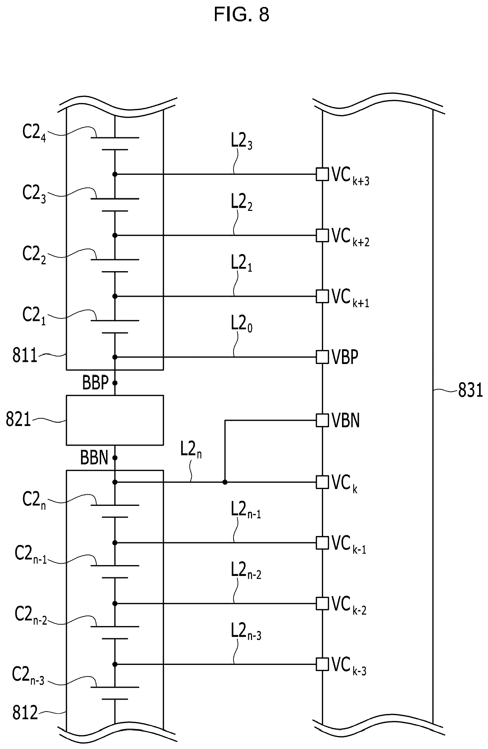

Next, a voltage measurement of a battery cell is described with reference to FIG. 8 to FIG. 9.

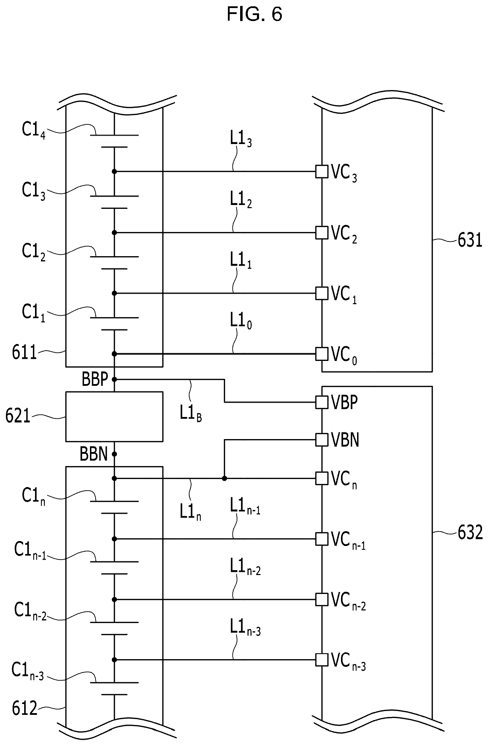

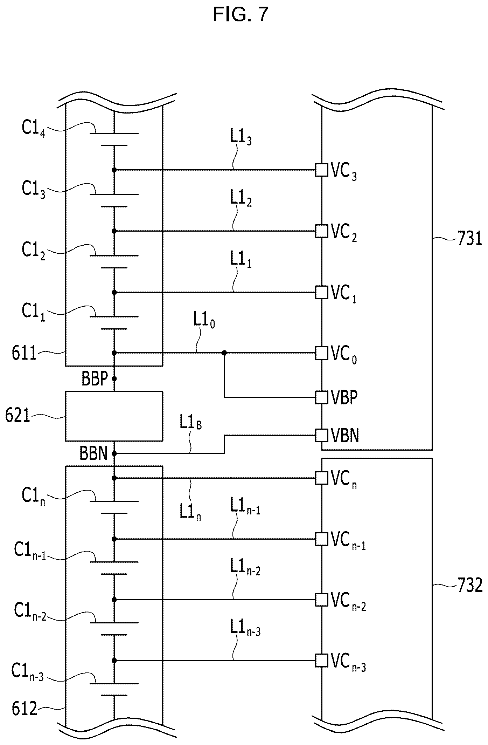

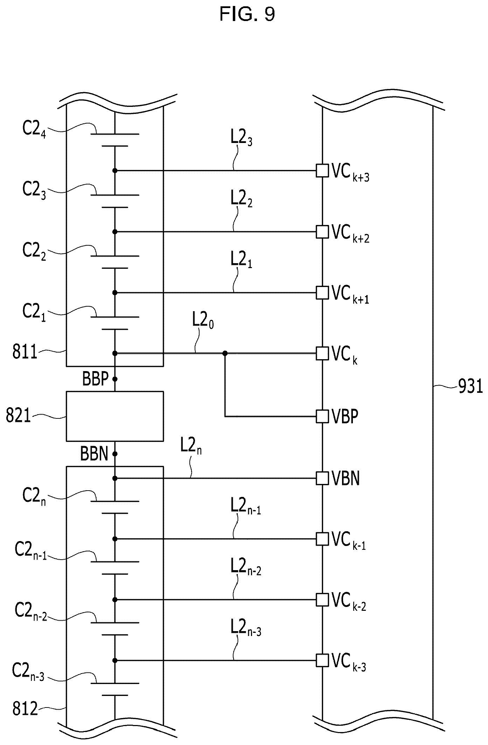

FIG. 6, FIG. 7 are diagrams of voltage for examples not part of the invention. FIG. 8, and FIG. 9 are diagrams for explaining a voltage measurement of a battery cell in a battery apparatus according to various embodiments. FIG. 8, and FIG. 9 shows only battery cells around a bus-bar among battery cells of a battery module for convenience of description.

First, examples not part of the invention in which two battery modules connected to a bus-bar are connected to different cell voltage sensing circuits are described with reference to FIG. 6 and FIG. 7. For example, as shown in FIG. 2, battery modules 212 and 213 may be connected to the cell voltage sensing circuits 231 and 232, respectively. Alternatively, as shown in FIG. 4, battery modules 212 and 213 may be connected to cell voltage sensing circuits 433 and 434, respectively.

Referring to FIG. 6, a separate cell voltage sensing circuit, which is not part of the invention, may be connected to each battery module. That is, a cell voltage sensing circuit 631 may be connected to a battery module 611, and a cell voltage sensing circuit 632 may be connected to a battery module 612. When the number of battery cells that can be sensed by the cell voltage sensing circuit 631 or 632 is less than the number of battery cells included in the battery module 611 or 612 (e.g., a case of FIG. 4), another cell voltage sensing circuit may be additionally connected to each battery module 611 or 612. The two battery modules 611 and 612 may be connected by a bus-bar 621.

A plurality of sensing lines of the cell voltage sensing circuit 631 are connected to a plurality of battery cells of the battery module 611. In order to measure a voltage of a battery cell, one sensing line is connected to a contact of two adjacent battery cells, i.e., a negative electrode of one battery cell and a positive electrode of another battery cell. In the battery module 611, a contact of two battery cells C1₁ and C1₂, i.e., a positive electrode of the battery cell C1₁ and a negative electrode of the battery cell C1₂ are connected to a sensing line L1₁, a contact of two battery cells C1₂ and C1₃, i.e., a positive electrode of the battery cell C1₂ and a negative electrode of the battery cell C1₃ are connected to a sensing line L1₂, and a contact of two battery cells C1₃ and C1₄, i.e., a positive electrode of the battery cell C1₃ and a negative electrode of the battery cell C1₄ are connected to a sensing line L1₃. In addition, a negative electrode of the battery cell C1₁ is connected to a sensing line L1₀. In some embodiments, the sensing lines L1₀, L1₁, L1₂, and L1₃ may be connected to a plurality of pins VC₀, VC₁, VC₂, and VC₃ for cell voltage sensing in the cell voltage sensing circuit 631, respectively.

Accordingly, the cell voltage sensing circuit 631 may measure a voltage of each battery cell based on a voltage difference between two adjacent corresponding sensing lines among the plurality of sensing lines L1₀, L1₁, L1₂, and L1₃. That is, the cell voltage sensing circuit 631 may measure, as the voltage of each battery cell, a voltage between a positive electrode of the corresponding battery cell and a positive electrode of an adjacent battery cell. In some embodiments, the cell voltage sensing circuit 631 may measure a voltage of each battery cell based on a voltage difference between two adjacent corresponding pins among the plurality of pins. For example, the cell voltage sensing circuit 631 may measure the voltage of the battery cell C1ᵢ based on the voltage difference between the two sensing lines L1ᵢ₋₁ and L1ᵢ (i.e., the voltage difference between the two pins VCᵢ₋₁ and VCᵢ, wherein i is an integer greater than or equal to one (1).

A plurality of sensing lines of the cell voltage sensing circuit 632 are connected to a plurality of battery cells of the battery module 612 and the bus-bar 621. In the battery module 612, a contact of two battery cells C1ₙ₋₁ and C1ₙ, i.e., a positive electrode of the battery cell C1ₙ₋₁ and a negative electrode of the battery cell C1ₙ are connected to a sensing line L1ₙ₋₁, a contact of two battery cells C1ₙ₋₂ and C1ₙ₋₁, i.e., a positive electrode of the battery cell C1ₙ₋₂ and a negative electrode of the battery cell C1ₙ₋₁ are connected to a sensing line L1ₙ₋₂, and a contact of two battery cells C1ₙ₋₃ and C1ₙ₋₂, i.e., a positive electrode of the battery cell C1ₙ₋₃ and a negative electrode of the battery cell C1ₙ₋₂ are connected to a sensing line L1ₙ₋₃. Further, a positive electrode of the battery cell C1ₙ is connected to a sensing line L1ₙ, and a second terminal BBN of the bus-bar 621 is connected to the sensing line L1ₙ through the positive electrode of the battery cell C1ₙ. Furthermore, a first terminal BBP of the bus-bar 621 is connected to a sensing line L1_{B}.

In some embodiments, the plurality of sensing lines L1ₙ₋₃, L1ₙ₋₂, L1ₙ₋₁, and L1ₙ may be connected to a plurality of pins VCₙ₋₃, VCₙ₋₂, VCₙ₋₁, and VCₙ for cell voltage sensing in the cell voltage sensing circuit 632, respectively. Further, the sensing line L1ₙ may be connected to a pin VBN for the bus-bar 621 in the cell voltage sensing circuit 632 as well as the pin VCₙ. Furthermore, the sensing line L1_{B} may be connected to another pin VBP for the bus-bar 621 in the cell voltage sensing circuit 632.

Accordingly, the cell voltage sensing circuit 632 may measure a voltage of each battery cell based on a voltage difference between two adjacent corresponding sensing lines among the plurality of sensing lines L1ₙ₋₃, L1ₙ₋₂, L1ₙ₋₁, and L1ₙ. That is, the cell voltage sensing circuit 632 may measure, as the voltage of each battery cell, a voltage between a positive electrode of the corresponding battery cell and a positive electrode of an adjacent battery cell. In some embodiments, the cell voltage sensing circuit 632 may measure the voltage of each battery cell based on a voltage difference between two adjacent corresponding pins among the plurality of pins VCₙ₋₃, VCₙ₋₂, VCₙ₋₁, and VCₙ. Further, the cell voltage sensing circuit 632 may measure the voltage of the bus-bar 621, i.e., a voltage between both terminals of the bus-bar 621 based on a voltage difference between the two sensing lines L1ₙ and L1_{B} (i.e., a voltage difference between the two pins VBP and VBN).

In some other embodiments, unlike the embodiment described with reference to FIG. 6, the cell voltage sensing circuits 631 and 632 may measure, as the voltage of each battery cell, a voltage between a negative electrode of the corresponding battery cell and a negative electrode of an adjacent battery cell. In this case, the voltage of the bus-bar 621 may be measured by the cell voltage sensing circuit 631. As shown in FIG. 7, a first terminal BBP of the bus-bar 621 may be connected to a sensing line L1₀ through the negative electrode of the battery cell C1₁ of the battery module 611. Further, a second terminal BBN of the bus-bar 621 may be connected to a sensing line L1_{B}. In some embodiments, the sensing line L1₀ may be connected to a pin VBP for the bus-bar 621 in the cell voltage sensing circuit 731 as well as a pin VC₀. Furthermore, the sensing line L1_{B} may be connected to another pin VBN for the bus-bar 621 in the cell voltage sensing circuit 732. Accordingly, the cell voltage sensing circuit 731 may measure the voltage of the bus-bar 621 based on a voltage difference between the two sensing lines L1₀ and L1_{B} (i.e., a voltage difference between the two pins VBP and VBN).

Next, embodiments in which two battery modules connected to a bus-bar are connected to the same cell voltage sensing circuit are described with reference to FIG. 8 and FIG. 9. For example, as shown in FIG. 2, FIG. 3, and FIG. 4, the battery modules 211 and 212 may be connected to the cell voltage sensing circuit 231, 331 or 432, or the battery modules 213 and 214 may be connected to the cell voltage sensing circuit 232, 333 or 435. Alternatively, as shown in FIG. 3, the battery modules 212 and 213 may be connected to the cell voltage sensing circuit 332.

Referring to FIG. 8, a cell voltage sensing circuit 831 is connected to battery modules 811 and 812 and a bus-bar 821 connecting the two battery modules 811 and 812 to measure a voltage of each of the battery cells and a voltage of the bus-bar 821. As described with reference to FIG. 2, FIG. 3, and FIG. 4, the cell voltage sensing circuit 831 is connected to some battery cells of the battery module 811 or 812 or to all battery cells of the battery module 811.

A plurality of sensing lines of the cell voltage sensing circuit 831 are connected to a plurality of battery cells of the battery modules 811 and 812, and a bus-bar 821, respectively. In order to measure a voltage of a battery cell, one sensing line is connected to a contact of two adjacent battery cells, i.e., a negative electrode of one battery cell and a positive electrode of another battery cell. In the battery module 811, a contact of two battery cells C2₁ and C2₂, i.e., a positive electrode of the battery cell C2₁ and a negative electrode of the battery cell C2₂ is connected to a sensing line L2₁, a contact of two battery cells C2₂ and C2₃, i.e., a positive electrode of the battery cell C2₂ and a negative electrode of the battery cell C2₃ are connected to a sensing line L2₂, and a contact of two battery cells C2₃ and C2₄, i.e., a positive electrode of the battery cell C2₃ and a negative electrode of the battery cell C2₄ are connected to a sensing line L2₃. Further, in the battery module 812, a contact of two battery cells C2ₙ₋₁ and C2ₙ, i.e., a positive electrode of the battery cell C2ₙ₋₁ and a negative electrode of the battery cell C2ₙ are connected to a sensing line L2ₙ₋₁, a contact of two battery cells C2ₙ₋₂ and C2ₙ₋₁, i.e., a positive electrode of the battery cell C2ₙ₋₂ and a negative electrode of the battery cell C2ₙ₋₁ are connected to a sensing line L2ₙ₋₂, and a contact of two battery cells C2ₙ₋₃ and C2ₙ₋₂, i.e., a positive electrode of the battery cell C2ₙ₋₃ and a negative electrode of the battery cell C2ₙ₋₂ are connected to a sensing line L2ₙ₋₃.

Because of the bus-bar 821, the negative electrode of the first battery cell C2₁ of the battery module 811 and a positive electrode of a battery cell adjacent to the battery cell C2₁, i.e., the last battery cell C2ₙ of the battery module 812 cannot be connected to the same sensing line. Accordingly, the negative electrode of the first battery cell C2₁ of the battery module 811 is connected to a sensing line L2₀, and the positive electrode of the last battery cell C2ₙ of the battery module 812 is connected to a sensing line L2ₙ. Since a first terminal BBP of the bus-bar 821 is connected to the negative electrode of the battery cell C2₁ which is a negative terminal of the battery module 811, the first terminal BBP of the bus-bar 821 is connected to the sensing line L2₀ through the the negative electrode of the battery cell C2₁. Further, since a second terminal BBN of the bus-bar 821 is connected to the positive electrode of the battery cell C2ₙ which is a positive terminal of the battery module 812, the second terminal BBN of the bus-bar 821 is connected to the sensing line L2ₙ through the positive electrode of the battery cell C2ₙ.

In some embodiments, the plurality of sensing lines L2₃, L2₂, L2₁, L2ₙ, L2ₙ₋₁, L2ₙ₋₂, and L2ₙ₋₃ may be connected to a plurality of pins VCₖ₊₃, VCₖ₊₂, VCₖ₊₁, VCₖ, VCₖ₋₁, VCₖ₋₂, and VCₖ₋₁ for cell voltage sensing in the cell voltage sensing circuit 831, respectively. Further, the sensing line L2ₙ may be connected to a pin VBN for the bus-bar 821 in the cell voltage sensing circuit 831 as well as a pin VCₖ. Furthermore, the sensing line L2₀ may be connected to another pin VBP for the bus-bar 821 in the cell voltage sensing circuit 831. In this case, the sensing line L2₀ is not connected to the pin for cell voltage sensing.

Accordingly, the cell voltage sensing circuit 831 measures a voltage of each battery cell based on based on a voltage difference between two adjacent corresponding sensing lines among the plurality of sensing lines L2₃, L2₂, L2₁, L2ₙ, L2ₙ₋₁, L2ₙ₋₂, and L2ₙ₋₃. That is, the cell voltage sensing circuit 831 measures as the voltage of each battery cell, a voltage between a positive electrode of the corresponding battery cell and a positive electrode of an adjacent battery cell. The cell voltage sensing circuit 831 measures a voltage of each battery cell based on a voltage difference between two adjacent corresponding pins among the plurality of pins VCₖ₊₃, VCₖ₊₂, VCₖ₊₁, VCₖ, VCₖ₋₁, VCₖ₋₂, and VCₖ₋₁.

In this case, the cell voltage sensing circuit 831 measures the voltage of the first battery cell C2₁ of the battery module 811 based on a voltage difference between the sensing lines L2₁ and L2ₙ (i.e., a voltage difference between the two pins VCₖ₊₁ and VCₖ). That is, since the voltage of the first battery cell C2₁ is measured as the voltage between the positive electrode of the battery cell C2₁ and the positive electrode of the adjacent battery cell (i.e., the last battery cell C2ₙ of the battery module 812), the voltage of the first battery cell C2₁ may be measured as a sum of an actual voltage of the battery cell C2₁ and the voltage of the bus-bar 821.

Accordingly, the cell voltage sensing circuit 831 may determine the voltage of the first battery cell C2₁ by correcting the measured voltage of the first battery cell C2₁ with the voltage of the bus-bar 821. In some embodiments, the cell voltage sensing circuit 831 may determine a voltage obtained by subtracting the voltage of the bus-bar 821 from the measured voltage of the first battery cell C2₁ as the voltage of the first battery cell C2₁. In this case, the cell voltage sensing circuit 831 may measure the voltage of the bus-bar 821 based on a voltage difference between the two sensing lines L2₀ and L2ₙ connected to the bus-bar 821 (i.e., a voltage difference between the two pins VBP and VBn).

In some other embodiments, unlike the embodiments described with reference to FIG. 8, a cell voltage sensing circuit 931 may measure, as a voltage of each battery cell, a voltage between a negative electrode of the corresponding battery cell and a negative electrode of an adjacent battery cell. As shown in FIG. 9, a first terminal BBP of a bus-bar 821 is connected to a sensing line L2₀ through the negative electrode of the battery cell C2₁. Further, since a second terminal BBN of the bus-bar 821 is connected to the positive electrode of the battery cell C2ₙ which is the positive terminal of the battery module 812, the second terminal BBN of the bus-bar 821 is connected to the sensing line L2ₙ through the positive electrode of the battery cell C2ₙ. In some embodiments, the sensing line L2₀ may be connected to a pin VBP for the bus-bar 821 in the cell voltage sensing circuit 931 as well as a pin VCₖ. Further, the sensing line L2ₙ may be connected to another pin VBN for the bus-bar 821 in the cell voltage sensing circuit 931. In this case, the sensing line L2ₙ is not connected to the pin for sensing the cell voltage.

In this case, the cell voltage sensing circuit 931 measures the voltage of the last battery cell C2ₙ of the battery module 812 based on a voltage difference between the sensing lines L2₀ and L2ₙ₋₁ (i.e., a voltage difference between the two pins VCₖ and VCₖ₋₁). That is, since the voltage of the last battery cell C2ₙ is measured as the voltage between the negative electrode of the battery cell C2ₙ and the negative electrode of the adjacent battery cell (i.e., the first battery cell C2₁ of the battery module 811), the voltage of the last battery cell C2ₙ may be measured as a sum of an actual voltage of the battery cell C2ₙ and the voltage of the bus-bar 821.

Accordingly, the cell voltage sensing circuit 931 may determine the voltage of the last battery cell C2ₙ by correcting the measured voltage of the last battery cell C2ₙ with the voltage of the bus-bar 821. In some embodiments, the cell voltage sensing circuit 931 may determine a voltage obtained by subtracting the voltage of the bus-bar 821 from the measured voltage of the last battery cell C2ₙ as the voltage of the last battery cell C2ₙ. In this case, the cell voltage sensing circuit 931 may measure the voltage of the bus-bar 821 based on a voltage difference between the two sensing lines L2₁ and L2ₙ₋₁ connected to the bus-bar 821 (i.e., a voltage difference between the two pins VBP and VBn).

According to the above-described embodiments, one cell voltage sensing circuit may be connected to a plurality of battery modules, and the voltage of the bus-bar included in the measured voltage of the battery cell may be compensated.

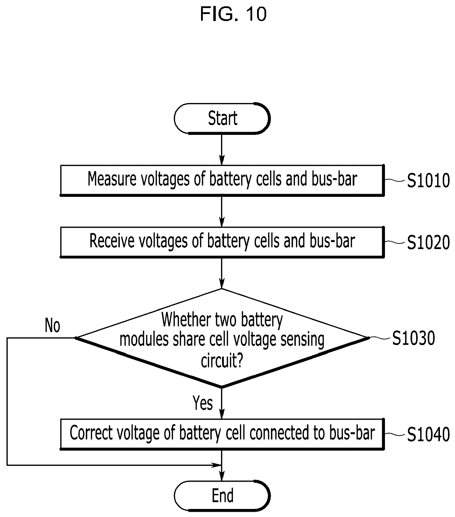

Next, a method of measuring a cell voltage in a battery apparatus according to an embodiment is described with reference to FIG. 10.

FIG. 10 is a flowchart showing a method of measuring a cell voltage in a battery apparatus according to an embodiment.

Referring to FIG. 10, a cell voltage sensing circuit of a battery management system measures voltages of battery cells of a battery module at S1010. Further, the cell voltage sensing circuit measures a voltage of a bus-bar at S1010. A processor (e.g., 140 in FIG. 1) receives the voltages of the battery cells and the voltage of the bus-bar from the cell voltage sensing circuit at S1020.

The processor 140 determines whether two battery modules share a cell voltage sensing circuit at S1030. That is, the processor 140 determines whether the voltage of the first battery cell of one battery module and the voltage of the last battery cell of another battery module are measured in the same cell voltage sensing circuit at S1030. When the two battery modules share the cell voltage sensing circuit, the processor 140 corrects the voltage of the battery cell (i.e., the first battery cell or the last battery cell) connected to the bus-bar based on the voltage of the bus-bar at S1040. In some embodiments, the processor 140 may correct the voltage of the battery cell connected to the busbar by subtracting the voltage of the busbar from the voltage of the battery cell connected to the busbar.

While this invention has been described in connection with what is presently considered to be practical embodiments, it is to be understood that the invention is not limited to the disclosed embodiments.

## Claims

1. A battery apparatus (100) comprising:
a plurality of battery modules including a first battery module (811, 911) and a second battery module (812, 912);
a cell voltage sensing means (831, 931) including a plurality of channels, shared by a plurality of battery cells of the first battery module (811, 911) and a plurality of battery cells of the second battery module (812, 912), and configured to measure a voltage of each battery cell based on the plurality of channels, wherein the plurality of channels includes a first channel (VBP) connected to a first battery cell (C2₁) among the plurality of battery cells of the first battery module (811, 911) and a second channel (VBN) connected to a second battery cell (C2ₙ) among the plurality of battery cells of the second battery module (812, 912); and
a processor (140) configured to correct a voltage of at least one battery cell among the plurality of battery cells of the first battery module (811, 911) and the plurality of battery cells of the second battery module (812, 912) based on a voltage between the first channel (VBP) and the second channel (VBN).

2. The battery apparatus (100) of claim 1, wherein the first battery cell (C2₁) is a battery cell having a negative electrode corresponding to a negative terminal of the first battery module (811, 911), and the second battery cell (C2ₙ) is a battery cell having a positive electrode corresponding to a positive terminal of the second battery module (812, 912).

3. The battery apparatus (100) of claim 2, wherein the first channel is connected to the negative electrode of the first battery cell (C2₁), and the second channel is connected to the positive electrode of the second battery cell (C2ₙ).

4. The battery apparatus (100) of any one of the preceding claims, wherein the at least one battery cell includes the first battery cell (C2₁) or the second battery cell (C2ₙ).

5. The battery apparatus (100) of any one of the preceding claims, wherein the processor (140) is further configured to correct the voltage of the at least one battery cell by subtracting the voltage between the first channel (VBP) and the second channel (VBN) from the voltage of the at least one battery cell measured by the cell voltage sensing means (831, 931).

6. The battery apparatus (100) of any one of the preceding claims, wherein the plurality of channels further include a third channel (VCₖ₊₁) connected to a positive electrode of the first battery cell (C2₁) and a fourth channel (VCₖ) connected to the positive electrode of the second battery cell (C2ₙ), and
wherein the processor (140) is further configured to measure a voltage of the first battery cell (C2₁) by correcting a voltage between the third channel (VCₖ₊₁) and the fourth channel (VCₖ) based on the voltage determined based on the first channel (VBP) and the second channel (VBN).

7. The battery apparatus (100) of any one of claims 1 to 5, wherein the plurality of channels further include a third channel (VCₖ) connected to the negative electrode of the first battery cell (C2₁) and a fourth channel (VCₖ₋₁) connected to a negative electrode of the second battery cell (C2ₙ), and
wherein the processor (140) is further configured to measure a voltage of the second battery cell (C2ₙ) by correcting a voltage between the third channel (VCₖ) and the fourth channel (VCₖ₋₁) based on the voltage determined based on the first channel (VBP) and the second channel (VBN).

8. The battery apparatus (100) of any one of the preceding claims, further comprising a bus-bar (821) connecting the first battery module (811, 911) and the second battery module (812, 912).

9. The battery apparatus (100) of claim 8, wherein a first terminal of the bus-bar (821) is connected to a negative electrode of the first battery cell (C2₁), and a second terminal of the bus-bar (821) is connected to a positive electrode of the second battery cell (C2ₙ).

10. The battery apparatus (100) of any one of the preceding claims, wherein the cell voltage sensing means (831, 931) is a cell voltage sensing circuit.

11. The battery apparatus (100) of claim 10, wherein the cell voltage sensing circuit is provided in a form of an integrated circuit (IC).

12. A method of measuring a cell voltage of a battery apparatus (100) including a first battery module (811, 911) and a second battery module (812, 912), the method comprising:
measuring a voltage between a first contact and a second contact, the first contact being a contact between a first terminal of the first battery module (811, 911) and a first battery cell (C2₁) among a plurality of battery cells included in the first battery module (811, 911), and the second contact being a contact between a second electrode terminal of the second battery module (812, 912) and a second battery cell (C2ₙ) among a plurality of battery cells included in the second battery module (812, 912); and
correcting a voltage of at least one battery cell among the plurality of battery cells included the first battery module (811, 911) and the plurality of battery cells included in the second battery module (812, 912) based on the voltage between the first contact and the second contact.

13. The method of claim 12, wherein the first terminal is a negative terminal of the first battery module (811, 911), and the second terminal is a positive terminal of the second battery module (812, 912).

14. The method of claim 12 or 13, wherein the at least one battery cell includes the first battery cell (C2₁) or the second battery cell (C2ₙ).

15. The method of any one of claims 12 to 14, wherein the battery apparatus (100) further includes a cell voltage sensing means (831, 931) including a plurality of channels, shared by a plurality of battery cells of the first battery module (811, 911) and a plurality of battery cells of the second battery module (812, 912), and configured to measure a voltage of each battery cell based on the plurality of channels, and
wherein the first contact is a first channel (VBP) connected to the first battery cell (C2₁), and the second contact is a second channel (VBN) connected to the second battery cell (C2ₙ).

## Patentansprüche

1. Batterievorrichtung (100), umfassend:
eine Vielzahl von Batteriemodulen, die ein erstes Batteriemodul (811, 911) und ein zweites Batteriemodul (812, 912) einschließt;
eine Zellspannungsmessvorrichtung (831, 931), die eine Vielzahl von Kanälen einschließt, die von einer Vielzahl von Batteriezellen des ersten Batteriemoduls (811, 911) und einer Vielzahl von Batteriezellen des zweiten Batteriemoduls (812, 912) gemeinsam genutzt werden, und die so konfiguriert ist, dass sie eine Spannung jeder Batteriezelle basierend auf der Vielzahl von Kanälen misst, wobei die Vielzahl von Kanälen einen ersten Kanal (VBP), der mit einer ersten Batteriezelle (C2₁) aus der Vielzahl von Batteriezellen des ersten Batteriemoduls (811, 911) verbunden ist, und einen zweiten Kanal (VBN), der mit einer zweiten Batteriezelle (C2ₙ) aus der Vielzahl von Batteriezellen des zweiten Batteriemoduls (812, 912) verbunden ist, einschließt; und
einen Prozessor (140), der so konfiguriert ist, dass er eine Spannung mindestens einer Batteriezelle aus der Vielzahl von Batteriezellen des ersten Batteriemoduls (811, 911) und der Vielzahl von Batteriezellen des zweiten Batteriemoduls (812, 912) basierend auf einer Spannung zwischen dem ersten Kanal (VBP) und dem zweiten Kanal (VBN) korrigiert.

2. Batterievorrichtung (100) nach Anspruch 1, wobei die erste Batteriezelle (C2₁) eine Batteriezelle ist, die eine negative Elektrode aufweist, die einem negativen Anschluss des ersten Batteriemoduls (811, 911) entspricht, und die zweite Batteriezelle (C2ₙ) eine Batteriezelle ist, die eine positive Elektrode aufweist, die einem positiven Anschluss des zweiten Batteriemoduls (812, 912) entspricht.

3. Batterievorrichtung (100) nach Anspruch 2, wobei der erste Kanal mit der negativen Elektrode der ersten Batteriezelle (C2₁) verbunden ist und der zweite Kanal mit der positiven Elektrode der zweiten Batteriezelle (C2ₙ) verbunden ist.

4. Batterievorrichtung (100) nach einem der vorstehenden Ansprüche, wobei die mindestens eine Batteriezelle die erste Batteriezelle (C2₁) oder die zweite Batteriezelle (C2ₙ) einschließt.

5. Batterievorrichtung (100) nach einem der vorstehenden Ansprüche, wobei der Prozessor (140) weiter so konfiguriert ist, dass er die Spannung der mindestens einen Batteriezelle korrigiert, indem er die Spannung zwischen dem ersten Kanal (VBP) und dem zweiten Kanal (VBN) von der durch die Zellspannungsmessvorrichtung (831, 931) gemessenen Spannung der mindestens einen Batteriezelle subtrahiert.

6. Batterievorrichtung (100) nach einem der vorstehenden Ansprüche, wobei die Vielzahl von Kanälen weiter einen dritten Kanal (VCₖ₊₁), der mit einer positiven Elektrode der ersten Batteriezelle (C2₁) verbunden ist, und einen vierten Kanal (VCₖ) einschließt, der mit der positiven Elektrode der zweiten Batteriezelle (C2ₙ) verbunden ist, und
wobei der Prozessor (140) weiter so konfiguriert ist, dass er eine Spannung der ersten Batteriezelle (C2₁) durch Korrigieren einer Spannung zwischen dem dritten Kanal (VCₖ₊₁) und dem vierten Kanal (VCₖ) basierend auf der Spannung, die basierend auf dem ersten Kanal (VBP) und dem zweiten Kanal (VBN) bestimmt wird, misst.

7. Batterievorrichtung (100) nach einem der Ansprüche 1 bis 5, wobei die Vielzahl von Kanälen weiter einen dritten Kanal (VCₖ), der mit der negativen Elektrode der ersten Batteriezelle (C2₁) verbunden ist, und einen vierten Kanal (VCₖ₋₁) einschließt, der mit einer negativen Elektrode der zweiten Batteriezelle (C2ₙ) verbunden ist, und
wobei der Prozessor (140) weiter so konfiguriert ist, dass er eine Spannung der zweiten Batteriezelle (C2ₙ) durch Korrigieren einer Spannung zwischen dem dritten Kanal (VCₖ) und dem vierten Kanal (VCₖ₋₁) basierend auf der Spannung, die basierend auf dem ersten Kanal (VBP) und dem zweiten Kanal (VBN) bestimmt wird, misst.

8. Batterievorrichtung (100) nach einem der vorstehenden Ansprüche, weiter umfassend eine Sammelschiene (821), die das erste Batteriemodul (811, 911) und das zweite Batteriemodul (812, 912) verbindet.

9. Batterievorrichtung (100) nach Anspruch 8, wobei ein erster Anschluss der Sammelschiene (821) mit einer negativen Elektrode der ersten Batteriezelle (C2₁) verbunden ist und ein zweiter Anschluss der Sammelschiene (821) mit einer positiven Elektrode der zweiten Batteriezelle (C2ₙ) verbunden ist.

10. Batterievorrichtung (100) nach einem der vorstehenden Ansprüche, wobei das Zellspannungs-Erfassungsmittel (831, 931) eine Zellspannungserfassungsschaltung ist.

11. Batterievorrichtung (100) nach Anspruch 10, wobei die Zellspannungserfassungsschaltung in Form einer integrierten Schaltung (IC) bereitgestellt ist.

12. Verfahren zum Messen einer Zellspannung einer Batterievorrichtung (100), die ein erstes Batteriemodul (811, 911) und ein zweites Batteriemodul (812, 912) einschließt, wobei das Verfahren umfasst:
Messen einer Spannung zwischen einem ersten Kontakt und einem zweiten Kontakt, wobei der erste Kontakt ein Kontakt zwischen einem ersten Anschluss des ersten Batteriemoduls (811, 911) und einer ersten Batteriezelle (C2₁) unter einer Vielzahl von in dem ersten Batteriemodul (811, 911) eingeschlossenen Batteriezellen ist und der zweite Kontakt ein Kontakt zwischen einem zweiten Elektrodenanschluss des zweiten Batteriemoduls (812, 912) und einer zweiten Batteriezelle (C2ₙ) unter einer Vielzahl von in dem zweiten Batteriemodul (812, 912) eingeschlossenen Batteriezellen ist; und
Korrigieren einer Spannung mindestens einer Batteriezelle unter der Vielzahl von in dem ersten Batteriemodul (811, 911) eingeschlossenen Batteriezellen und der Vielzahl von in dem zweiten Batteriemodul (812, 912) eingeschlossenen Batteriezellen basierend auf der Spannung zwischen dem ersten Kontakt und dem zweiten Kontakt.

13. Verfahren nach Anspruch 12, wobei der erste Anschluss ein negativer Anschluss des ersten Batteriemoduls (811, 911) ist und der zweite Anschluss ein positiver Anschluss des zweiten Batteriemoduls (812, 912) ist.

14. Verfahren nach Anspruch 12 oder 13, wobei die mindestens eine Batteriezelle die erste Batteriezelle (C2₁) oder die zweite Batteriezelle (C2ₙ) einschließt.

15. Verfahren nach einem der Ansprüche 12 bis 14, wobei die Batterievorrichtung (100) weiter ein Zellspannungs-Erfassungsmittel (831, 931) einschließt, das eine Vielzahl von Kanälen einschließt, die von einer Vielzahl von Batteriezellen des ersten Batteriemoduls (811, 911) und einer Vielzahl von Batteriezellen des zweiten Batteriemoduls (812, 912) gemeinsam genutzt werden und so konfiguriert sind, dass sie eine Spannung jeder Batteriezelle basierend auf der Vielzahl von Kanälen messen, und
wobei der erste Kontakt ein erster Kanal (VBP) ist, der mit der ersten Batteriezelle (C2₁) verbunden ist, und der zweite Kontakt ein zweiter Kanal (VBN) ist, der mit der zweiten Batteriezelle (C2ₙ) verbunden ist.

## Revendications

1. Appareil (100) à batterie comprenant :
une pluralité de modules de batterie incluant un premier module de batterie (811, 911) et un deuxième module de batterie (812, 912) ;
un moyen (831, 931) de détection de tension de cellule incluant une pluralité de canaux, partagés par une pluralité de cellules de batterie du premier module de batterie (811, 911) et une pluralité de cellules de batterie du deuxième module de batterie (812, 912), et configuré pour mesurer une tension de chaque cellule de batterie sur la base de la pluralité de canaux, dans lequel la pluralité de canaux incluent un premier canal (VBP) connecté à une première cellule de batterie (C2₁) parmi la pluralité de cellules de batterie du premier module de batterie (811, 911) et un deuxième canal (VBN) connecté à une deuxième cellule de batterie (C2ₙ) parmi la pluralité de cellules de batterie du deuxième module de batterie (812, 912) ; et
un processeur (140) configuré pour corriger une tension d'au moins une cellule de batterie parmi la pluralité de cellules de batterie du premier module de batterie (811, 911) et la pluralité de cellules de batterie du deuxième module de batterie (812, 912) sur la base d'une tension entre le premier canal (VBP) et le deuxième canal (VBN).

2. Appareil (100) à batterie selon la revendication 1, dans lequel la première cellule de batterie (C2₁) est une cellule de batterie présentant une électrode négative correspondant à une borne négative du premier module de batterie (811, 911), et la deuxième cellule de batterie (C2ₙ) est une cellule de batterie présentant une électrode positive correspondant à une borne positive du deuxième module de batterie (812, 912).

3. Appareil (100) à batterie selon la revendication 2, dans lequel le premier canal est connecté à l'électrode négative de la première cellule de batterie (C2₁), et le deuxième canal est connecté à l'électrode positive de la deuxième cellule de batterie (C2ₙ).

4. Appareil (100) à batterie selon l'une quelconque des revendications précédentes, dans lequel l'au moins une cellule de batterie inclut la première cellule de batterie (C2₁) ou la deuxième cellule de batterie (C2ₙ).

5. Appareil (100) à batterie selon l'une quelconque des revendications précédentes, dans lequel le processeur (140) est en outre configuré pour corriger la tension de l'au moins une cellule de batterie en soustrayant la tension entre le premier canal (VBP) et le deuxième canal (VBN) de la tension de l'au moins une cellule de batterie mesurée par le moyen (831, 931) de détection de tension de cellule.

6. Appareil (100) à batterie selon l'une quelconque des revendications précédentes, dans lequel la pluralité de canaux inclut en outre un troisième canal (VCₖ₊₁) connecté à une électrode positive de la première cellule de batterie (C2₁) et un quatrième canal (VCₖ) connecté à l'électrode positive de la deuxième cellule de batterie (C2ₙ), et
dans lequel le processeur (140) est en outre configuré pour mesurer une tension de la première cellule de batterie (C2₁) en corrigeant une tension entre le troisième canal (VCₖ₊₁) et le quatrième canal (VCₖ) sur la base de la tension déterminée sur la base du premier canal (VBP) et du deuxième canal (VBN).

7. Appareil (100) à batterie selon l'une quelconque des revendications 1 à 5, dans lequel la pluralité de canaux inclut en outre un troisième canal (VCₖ) connecté à l'électrode négative de la première cellule de batterie (C2₁) et un quatrième canal (VCₖ₋₁) connecté à une électrode négative de la deuxième cellule de batterie (C2ₙ), et
dans lequel le processeur (140) est en outre configuré pour mesurer une tension de la deuxième cellule de batterie (C2ₙ) en corrigeant une tension entre le troisième canal (VCₖ) et le quatrième canal (VCₖ₋₁) sur la base de la tension déterminée sur la base du premier canal (VBP) et du deuxième canal (VBN).

8. Appareil (100) à batterie selon l'une quelconque des revendications précédentes, comprenant en outre une barre omnibus (821) connectant le premier module de batterie (811, 911) et le deuxième module de batterie (812, 912).

9. Appareil (100) à batterie selon la revendication 8, dans lequel une première borne de la barre omnibus (821) est connectée à une électrode négative de la première cellule de batterie (C2₁), et une deuxième borne de la barre omnibus (821) est connectée à une électrode positive de la deuxième cellule de batterie (C2ₙ).

10. Appareil (100) à batterie selon l'une quelconque des revendications précédentes, dans lequel le moyen (831, 931) de détection de tension de cellule est un circuit de détection de tension de cellule.

11. Appareil (100) à batterie selon la revendication 10, dans lequel le circuit de détection de tension de cellule est fourni sous forme d'un circuit intégré (CI).

12. Procédé de mesure d'une tension de cellule d'un appareil (100) à batterie incluant un premier module de batterie (811, 911) et un deuxième module de batterie (812, 912), le procédé comprenant :
la mesure d'une tension entre un premier contact et un deuxième contact, le premier contact étant un contact entre une première borne du premier module de batterie (811, 911) et une première cellule de batterie (C2₁) parmi une pluralité de cellules de batterie incluses dans le premier module de batterie (811, 911), et le deuxième contact étant un contact entre une deuxième borne d'électrode du deuxième module de batterie (812, 912) et une deuxième cellule de batterie (C2ₙ) parmi une pluralité de cellules de batterie incluses dans le deuxième module de batterie (812, 912) ; et
la correction d'une tension d'au moins une cellule de batterie parmi la pluralité de cellules de batterie incluses dans le premier module de batterie (811, 911) et la pluralité de cellules de batterie incluses dans le deuxième module de batterie (812, 912) sur la base de la tension entre le premier contact et le deuxième contact.

13. Procédé selon la revendication 12, dans lequel la première borne est une borne négative du premier module de batterie (811, 911), et la deuxième borne est une borne positive du deuxième module de batterie (812, 912).

14. Procédé selon la revendication 12 ou la revendication 13, dans lequel l'au moins une cellule de batterie inclut la première cellule de batterie (C2₁) ou la deuxième cellule de batterie (C2ₙ).

15. Procédé selon l'une quelconque des revendications 12 à 14, dans lequel l'appareil (100) à batterie inclut en outre un moyen (831, 931) de détection de tension de cellule incluant une pluralité de canaux, partagés par une pluralité de cellules de batterie du premier module de batterie (811, 911) et une pluralité de cellules de batterie du deuxième module de batterie (812, 912), et configuré pour mesurer une tension de chaque cellule de batterie sur la base de la pluralité de canaux, et
dans lequel le premier contact est un premier canal (VBP) connecté à la première cellule de batterie (C2₁), et le deuxième contact est un deuxième canal (VBN) connecté à la deuxième cellule de batterie (C2ₙ).
